# EUROPÄISCHE PATENTSCHRIFT

(11) **EP 1 828 544 B1**
(45) Veröffentlichungstag und Bekanntmachung des Hinweises auf die Patenterteilung: **22.06.2011**
(21) Anmeldenummer: 05821611.0
(22) Anmeldetag: 20.12.2005
(51) Int. Cl.: F01D 5/18, B23P 15/00, C03B 11/00, C03B 13/00

(54) **VERFAHREN ZUR HERSTELLUNG EINES BAUTEILS MIT EINGEBETTETEM KANAL SOWIE BAUTEIL**
METHOD TO PRODUCE A COMPONENT COMPRISING AN EMBEDDED CHANNEL AND COMPONENT
PROCEDE DE PRODUCTION D'UN COMPOSANT COMPRENANT UN CANAL INCORPORE ET COMPOSANT

(30) Priorität: 24.12.2004 CH 214704
(43) Veröffentlichungstag der Anmeldung: 05.09.2007
(73) Patentinhaber: Alstom Technology Ltd, 5400 Baden (CH)
(72) Erfinder: BEZENÇON, Cyrille, CH-3971 Chermignon (CH); FEHRMANN, Bernd, CH-5415 Nussbaumen (CH); HOEBEL, Matthias, CH-5210 Windisch (CH); KONTER, Maxim, CH-5313 Klingnau (CH); KURZ, Wilfrid, CH-1093 La Conversion S. Lutry (CH); WAGNIÈRE, Jean-Daniel, CH-1034 Boussens (CH)
(86) Internationale Anmeldenummer: PCT/EP2005/056979
(87) Internationale Veröffentlichungsnummer: WO 2006/069941

(56) Entgegenhaltungen:
- EP-A- 1 001 055
- EP-A- 1 295 970
- EP-A- 1 462 611
- US-A- 5 640 767
- US-B1- 6 405 435

## Beschreibung

Die vorliegende Erfindung betrifft ein Verfahren zur Herstellung eines Bauteils, insbesondere einer Heissgaskomponente einer Strömungsmaschine, mit zumindest einem in eine Außenwand des Bauteils eingebetteten und im wesentlichen parallel und nahe zur Oberfläche des Bauteils verlaufenden Kanal, welcher insbesondere zur Aufnahme eines Kühlmittels dienen soll.

Die Erfindung betrifft darüber hinaus ein nach diesem Verfahren hergestelltes Bauteil.

### Stand der Technik

Moderne Strömungsmaschinen, wie beispielsweise Gasturbinen, sind während des Betriebs hohen Belastungen ausgesetzt. Sie werden oftmals mit mehr als 800°C heißen Gasen betrieben und unterliegen zugleich hohen mechanischen Belastungen. Die Zunahme der Turbinenleistungsfähigkeit während der letzten Dekaden basiert im Grunde nach auf zwei Verbesserungen. Einerseits wurden stetig neue leistungsfähige Werkstoffe entwickelt, wie beispielsweise Ein-Kristall-Legierungen, wodurch die Belastbarkeit der im Strömungsquerschnitt der Heissgase liegenden Bauteile gesteigert werden konnte, und zum anderen wurden immer wieder verbesserte Kühlsysteme und Temperaturschutzschichten entwickelt, welche eine Steigerung der Turbineneintrittstemperaturen und damit eine Steigerung der Turbinenleistung zur Folge hatten. Insbesondere die Ein-Kristall-Legierungen, wie beispielsweise CMSX2, CMSX4 oder MK4, haben zu einer deutlichen Reduzierung der Temperaturempfindlichkeit und damit zu deutlich verbesserten mechanischen Eigenschaften bei hohen Temperaturen geführt. Da die Leistungsfähigkeit der Gasturbinen direkt mit der Eintrittstemperatur der Heissgase gekoppelt ist, ist seit Jahren ein kontinuierlicher Anstieg der Heissgastemperatur zu verzeichnen, so dass insbesondere in den ersten Turbinenstufen bereits Gastemperaturen erreicht werden, die die Schmelztemperaturen der dort verwendeten Legierungen übersteigen. Um eine Beschädigung der Heissgaskomponenten bzw. der eingesetzten Legierungen zu verhindern, wurden komplexe interne Kühlsysteme entwickelt, die die im Strömungsquerschnitt liegenden Komponenten derart kühlen, dass diese unterhalb einer kritischen Temperaturgrenze, bei welcher die Bauteile Schaden nehmen würden, liegen. Allen Kühlsystemen ist dabei gemein, dass ein Kompromiss zwischen dem gewünschten Kühleffekt, der Menge der vorhandenen Kühlluft und den Kosten gebildet werden muss.

Die zur Kühlung erforderliche Kühlluft wird im allgemeinen von einem Kompressor geliefert und durch ein internes Kühlsystem auf die zu kühlenden Komponenten verteilt.

In der Regel werden verschiedene Kühlverfahren kombiniert, wie beispielsweise solche auf einem konvektiven Wärmeübergang beruhende Verfahren mit einer Film- oder Transpirationskühlung. In diesem Falle weisen die Bauteile beispielsweise interne, serpentinenartig verlaufende Kühlkanäle auf, welche mit einer Mehrzahl von Austrittsöffnungen an einer Oberfläche des Bauteils kommunizierend zusammenwirken, wodurch eine Film- oder Transpirationskühlung erzeugt wird. Eine besonders effektive Kühlung wird dabei erreicht, wenn die zu kühlende Wand eine möglichst geringe Wandstärke aufweist (EP 0 964 981).

Berechnungen haben nachgewiesen, dass bei einer Ausgestaltung eines Kühlverfahrens eines Heissgasbauteils dahingehend, dass ein oberflächennahes System von Kühlkanälen geschaffen wird, welche wenigstens an ihrem einen Ende mit den internen, meist serpentinenförmig das Schaufelinnere durchziehenden Kühlmittelkanälen kommunizieren, während mindestens ein anderes Ende mit Kühlpfaden verbunden ist, die zur Oberfläche führen und dort eine Film- oder Transpirationskühlung verwirklichen, ohne zusätzlichen Kühlluftverbrauch zu einer Erhöhung der Turbineneingangstemperatur um 50K bis 125K und damit zu einer signifikanten Verbesserung der Maschinenleistung führen.

Da jedoch durch die Kühlung der Komponenten, insbesondere der Turbinenschaufeln, der Gesamtwirkungsgrad der Kraftwerksanlage abnimmt, muss auch hier ein Kompromiss zwischen Turbinenleistung und Turbinenkühlung gefunden werden.

Ein anderes leistungsfähiges, konvektives Kühlsystem wird mittels kühlbarer Wandstrukturen verwirklicht, wie sie beispielsweise in EP 1 462 611, ∼612, ∼613 vorgestellt werden. Hierbei sind die Wände der Heissgaskomponenten mit einem Netz von Kühlkanälen ausgestattet. Im Interesse einer wirksamen Kühlung ist es vorteilhaft, diese Wände sehr dünn auszuführen und die Kühlkanäle nahe der thermisch beanspruchten Oberfläche zu verlegen. Auf diese Weise gelingt es, eine leistungsfähige Kühlung zur Verfügung zu stellen. Jedoch sind derartige interne Kühlkanäle fertigungstechnisch äußerst kompliziert herzustellen und daher unverhältnismäßig teuer.

Zur Minderung dieses Nachteils ist ein Verfahren zur Herstellung oder Reparatur von oberflächennahen Kühlkanälen in einer Heissgaskomponente einer Gasturbine bekanntgeworden, welches im wesentlichen darauf beruht, dass auf einem Grundkörper dieser Komponente ein Profil aufgebracht wird, welches der späteren Struktur der Kühlkanäle entspricht. Dies kann entweder in der Weise erfolgen, indem ein thermisch stabiles Füllmaterial in entsprechender Struktur auf die Oberfläche des Grundkörpers aufgebracht wird, oder zunächst diese Struktur mechanisch aus der Grundkörperoberfläche herausgearbeitet und die so entstandenen Vertiefungen anschliessend mit dem thermisch stabilen Füllmaterial ausgefüllt werden. In einem nachfolgenden Schritt wird mittels eines Beschichtungsverfahrens zumindest im Bereich der Kühlstruktur ein Überzugsmaterial aufgebracht. Durch nachträgliche Entfernung des Füllmaterials werden die Kühlkanäle freigelegt.

Dieser gattungsbildende Vorschlag ist in EP 1 065 026 sowie in späteren Veröffentlichungen, wie EP 1 462 611 und ∼12, offenbart.

Durch diese Lösungen wird es einerseits möglich, ein Kühlkanalnetz in einem Bauteil einer Strömungsmaschine zu schaffen, das einerseits durch seine knapp unterhalb der Oberfläche der Außenwand angeordnete Lage eine effiziente Kühlung des Bauteils bewirkt und andererseits auf aufwändige Gussformen verzichten kann und niedrigere Ausschussraten zur Folge hat. Generell können die in die Außenwand des Bauteils eingebetteten Kühlkanäle auch mit anderen Kühlstrategien, wie beispielsweise der oben beschriebenen Transpirationskühlung kombiniert werden, wodurch eine hohe Flexibilität und ein verbreitertes Einsatzspektrum erreicht werden können.

Nachteilig ist bei diesem Verfahren aber immer noch der relativ hohe Fertigungsaufwand, insbesondere das regelmässige Erfordernis einer Nachbehandlung zur nachträglichen Entfernung des Füllmaterials.

### Darstellung der Erfindung

Hier setzt die Erfindung an. Der Erfindung, wie sie in den Ansprüchen gekennzeichnet ist, liegt die Aufgabe zugrunde, ein Verfahren zur Herstellung eines Bauteils einer Strömungsmaschine der eingangs genannten Art bereitzustellen, welches insbesondere einen stark reduzierten Fertigungsaufwand besitzt, indem die Nachbehandlung des Bauteils zur Entfernung von Füllmaterial und zur Freilegung der hergestellten Kühlkanäle entfällt. Darüber hinaus liegt der Erfindung die Aufgabe zugrunde, ein nach diesem Verfahren hergestelltes Bauteil mit zumindest einem in eine Aussenwand eingebetteten Kanal bereitzustellen.

Diese Aufgaben werden erfindungsgemäß durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, bei einem Bauteil einer Strömungsmaschine der eingangs genannten Art in einem ersten Schritt zunächst die Struktur der Kühlmittelkanäle auf der Oberfläche des Grundkörpers zu erzeugen und in einem weiteren Schritt ein Beschichtungsmaterial unter direkter Überbrückung der erzeugten Kühlmittelkanäle, ohne dass diese mit einem Füllmaterial maskiert sind, aufzutragen, wobei sich das Beschichtungsmaterial epitaxial auf den Grundkörper aufbaut.

Indem eine Kanallängsachse weniger als 3 mm von der Oberfläche des Bauteils beabstandet ist, ist eine direkte und schnelle Übertragung der Kühlwirkung auf die Oberfläche möglich, wodurch ein besonders hoher Kühleffekt erzeugt werden kann. Darüber hinaus ist hierbei denkbar, dass mehrere Kanäle ein kommunizierendes Kanalnetz bilden und somit eine gleichmäßige flächige Kühlung der Oberfläche des Bauteils bewirken. Durch unterschiedliche Querschnitte innerhalb des Kühlkanalnetzes kann darüber hinaus Einfluss auf die genaue Verteilung der Kühlluft im Bauteil genommen werden, so dass beispielsweise stärker zu kühlende Bereiche mit Kühlkanälen größeren Querschnitts ausgestattet sind, wohingegen weniger stark zu kühlende Bereiche Kühlkanäle mit kleinerem Querschnitt aufweisen.

Eine Breite der Vertiefung ist zumindest im Bereich einer Oberfläche kleiner als 1 mm. Vorzugsweise liegt die Breite sogar bei lediglich 0,2 mm, wodurch ein Überbrücken der Vertiefungsbreite durch die aufgebrachte Beschichtung vereinfacht wird. Auch wird bei einer geringen Vertiefungsbreite ein zu starkes Eindringen der aufgebrachten Beschichtung in die Vertiefung vermieden, da die beiden Ränder bzw. Vertiefungswände im Vergleich zur eingedrungenen Beschichtungsmenge eine große Oberfläche besitzen und dadurch ein schnelles Erstarren der Beschichtung bewirken. Die geringe Breite der Vertiefung hat darüber hinaus den Vorteil, dass ein im Vergleich zu Vertiefungen mit größerer Breite engmaschigeres Netz von Kühlkanälen auf der Oberfläche des Bauteils, respektive einer Turbinenschaufel, gezogen werden kann, und dadurch eine gleichmäßigere bzw. individuell besser anpassbare Kühlleistung erzielt werden kann.

Durch die erfindungsgemäße Lösung wird es somit möglich, eine Anzahl von Kühlkanälen in einem Bauteil einer Strömungsmaschine zu schaffen, das einerseits einfach herzustellen ist und andererseits durch seine knapp unterhalb der Oberfläche der Außenwand angeordnete Lage eine effiziente Kühlung des Bauteils bewirkt, wobei eine aufwändige Nachbehandlung des Bauteils zum Zwecke der Entfernung von Füllmaterial und zur Freilegung der hergestellten Kühlmittelkanäle entfallen kann. Herstellungsaufwand und damit auch -kosten können deutlich reduziert werden. Die in den Grundkörper eingebrachten Vertiefungen können ebenso wie die Beschichtung voll automatisch hergestellt bzw. aufgebracht werden, wodurch sich eine besonders hohe Qualität und damit eine hohe Lebensdauer der Bauteile ergeben.

Generell können die in die Außenwand des Bauteils eingebetteten Kühlkanäle auch mit anderen Kühlstrategien, wie beispielsweise der oben beschriebenen Transpirationskühlung kombiniert werden, wodurch eine besonders hohe Flexibilität und ein verbreitertes Einsatzspektrum erreicht werden können.

Der Grundkörper weist eine gleichgerichtete Körner- und/oder EinKristallstruktur auf. Von Ein-Kristallstrukturen spricht man dann, wenn die Bausteine des Kristalls, also die Ionen, Atome oder Moleküle, ein einheitliches homogenes Kristallgitter bilden. Durch einen derartigen Ein-Kristall kann ein Abrutschen der Körner entlang der Korngrenzen, beispielsweise durch die Fliehkräfte, die in der Turbine herrschen, vermieden werden, da es bei Ein-Kristallen nur noch ein einziges Korn gibt, das gleichzeitig der Kristall ist.

Bei einer weiteren vorteilhaften Ausführungsform der Erfindung kommuniziert in an sich bekannter Weise zumindest ein Kanal mit wenigstens einer an der Oberfläche des Bauteils mündenden Austrittsöffnung. Hierdurch wird das besonders effektive dicht unterhalb der Oberfläche verlaufende Kühlsystem mit einer bekannten Filmkühlung kombiniert, welche durch permanenten Austritt von Kühlluft über die Austrittsöffnungen einen sich über die Oberfläche des Bauteils verteilenden Kühlmittelfilm erzeugt. Hierbei handelt es sich um ein sogenanntes offenes Kühlsystem, bei welchem von einer Kühlmittelquelle relativ hohen Drucks her, beispielsweise abgezweigt aus dem Kompressor einer Gasturbinenanlage, permanent Kühlmittel, in der Regel Luft, in das zu kühlende Bauteil durch dessen interne Kühlkanäle bis hin zu den Austrittsöffnungen in der Aussenwand geleitet wird.

Weitere wichtige Merkmale und Vorteile der erfindungsgemäßen Lösung ergeben sich aus den Unteransprüchen, aus den Zeichnungen und aus der zugehörigen Figurenbeschreibung anhand der Zeichnungen.

### Kurze Beschreibung der Zeichnung

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: ein erfindungsgemässes Bauteil mit teilweise sichtbar gemachten und in die Außenwand des Bauteils eingebetteten Kanälen,
- Fig. 2: einen Querschnitt durch das Bauteil entlang einer Schnittebene II- II,
- Fig. 3: eine Detaildarstellung von in die Außenwand des Bauteils eingebetteten Kühlkanälen,
- Fig. 4: einen stark vergrößerten Ausschnitt eines Querschnitts im Bereich der den Kanal verschließenden Beschichtung,
- Fig. 5: eine Darstellung wie in Fig. 4, jedoch mit zuvor erwärmtem Grundkörper,
- Fig. 6: eine Ansicht wie in Fig. 3, jedoch bei einer anderen Ausführungsform.

### Wege zur Ausführung der Erfindung

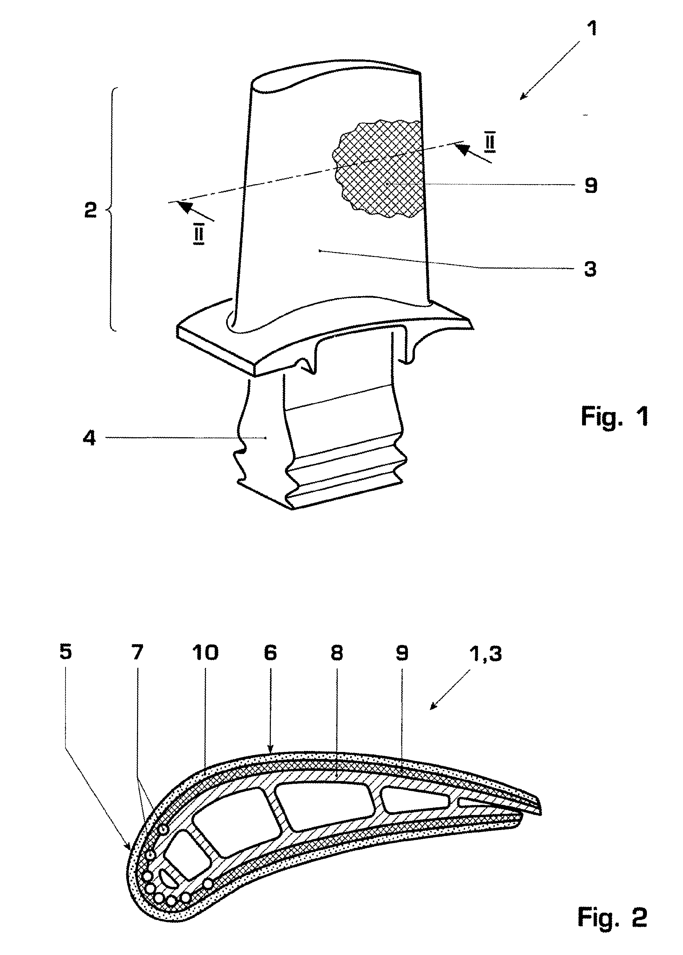

Entsprechend Fig. 1 weist ein Bauteil 1 einer im Übrigen nicht dargestellten Strömungsmaschine einen Bereich 2 auf, der beim Betrieb der Strömungsmaschine von Heißgasen umströmt ist. Bei dem Bauteil 1 kann es sich, wie in Fig. 1 beispielhaft dargestellt, um eine Schaufel 3, Leitschaufel oder Laufschaufel, einer Gasturbine handeln. An ihrem Einspannende mündet die Schaufel 3 in einen Schaufelfuß 4, mit welchem diese beispielsweise an einem Stator oder einem Rotor befestigt ist. Um die Leistungsfähigkeit der Turbine zu steigern, sind möglichst hohe Turbineneintrittstemperaturen erwünscht. Die hohen Turbineneintrittstemperaturen beeinträchtigen jedoch die Lebensdauer der mit Heißgas beaufschlagten Bauteile 1, sofern diese nicht ausreichend geschützt sind. Zum Schutz der Bauteile 1 vor den hohen Temperaturen der Heißgase werden prinzipiell zwei unterschiedliche Wege beschritten. Einerseits wird versucht, die Temperaturbeständigkeit der mit den Heißgasen in direktem Kontakt stehenden Bauteile 1 durch eine entsprechende Materialauswahl, wie beispielsweise durch den Einsatz von Nickel basierten Legierungen und/oder Wärmeschutzschichten, positiv zu beeinflussen und andererseits werden die Bauteile 1 aktiv gekühlt.

Ein gutes Beispiel für den Fortschritt in der Materialwissenschaft sind sogenannte Einkristalllegierungen, wie beispielsweise CMSX2, CMSX4 oder MK4, die häufig im modernen Maschinenbau verwendet werden. Als Einkristalle werden Kristalle bezeichnet, deren Bausteine ein einheitliches, homogenes Kristallgitter bilden.

Neben der angesprochenen Materialauswahl kann die Schaufel 3 darüber hinaus durch eine Kühlung vor einer Beschädigung durch die Heißgase geschützt werden.

Gemäß Fig. 2 weist die Schaufel 3 hierzu zumindest in einem Bereich einer Außenwand 5 eingebettete und im wesentlichen parallel zur Oberfläche 6 des Bauteils 1 bzw. der Schaufel 3 verlaufendende Kanäle 7,7', insbesondere Kühlkanäle, auf. Das Bauteil 1 besitzt einen Grundkörper 8, der beispielsweise eine gleichgerichtete Körnung aufweist und zumindest eine außenseitig auf dem Grundkörper 8 aufgebrachte Beschichtung 9, beispielsweise eine Verbindungsschicht. Der Kanal 7,7' ist dabei einerseits durch eine in den Grundkörper 8 eingebrachte Vertiefung gebildet und andererseits zur Oberfläche 6 des Bauteils 1 hin durch die Beschichtung 9 verschlossen. Darüber hinaus kann vorgesehen sein, dass die Beschichtung 9 außen eine Wärmeschutzschicht 10 trägt. Die Beschichtung 9 kann dabei beispielsweise eine metallische Beschichtung sein, die den Grundkörper 8 vor heißer Temperaturoxidation und -korrosion schützt. Dabei kann die Beschichtung 9 aus dem selben Material wie der Grundkörper 8 bestehen und/oder beispielsweise eine MCRALY-Legierung sein, wobei M für Nickel, Kobalt, Eisen oder eine Kombination aus diesen Elementen steht. Die vorzugsweise metallische Beschichtung 9 kann dabei eine Schichtdicke von 100 µm bis 600 µm aufweisen. Neben der Schutzfunktion erfüllt die Beschichtung 9 eine weitere Funktion, nämlich die Bereitstellung einer Adhäsionsschicht für die außen an der Beschichtung 9 angeordnete Temperatur-/Wärmeschutzschicht 10. Die Wärmeschutzschicht 10 kann dabei aus einem keramischen Material, wie beispielsweise ZrO₂, gebildet werden und verringert aufgrund ihrer isolierenden Wirkung die thermische Belastung für die darunter liegenden Komponenten. Die Wärmeschutzschicht 10 kann beispielsweise mittels eines Plasmaspray-Prozesses oder eines Elektronenstrahl-Verdampfungs-Prozesses aufgebracht werden.

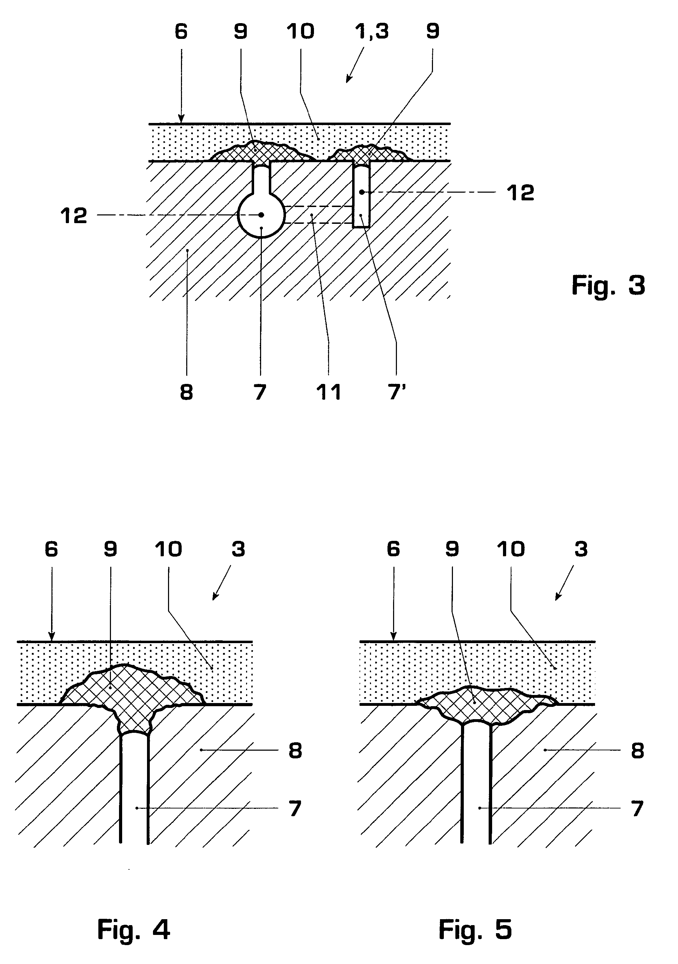

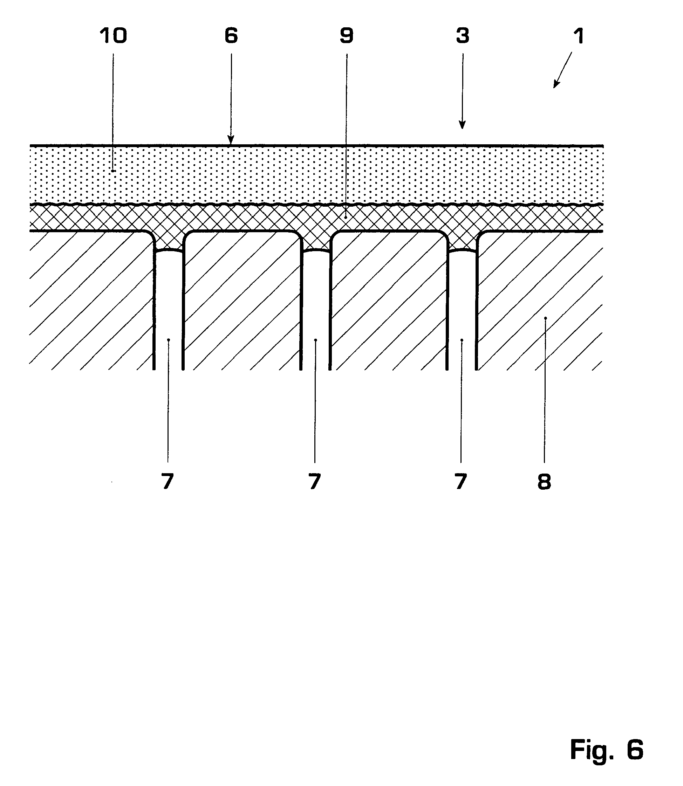

Fig. 3 zeigt einen detaillierten Querschnitt im Bereich der Oberfläche 6 des Bauteils 1 bzw. der Schaufel 3, wobei exemplarisch zwei Kanäle 7 und 7' dargestellt sind, die sich in ihrem Querschnitt unterscheiden. Die Kühlkanäle 7, 7' sind dabei in den Grundkörper 8 eingebettet und besitzen eine Öffnung zur zunächst unbeschichteten Oberfläche des Grundkörpers 8 hin. Wie in Fig. 3 gezeigt, sind die Öffnungen der Kanäle 7 und 7' durch die jeweils im Öffnungsbereich angeordnete Beschichtung 9 überbrückt und verschlossen. Dabei kann die Beschichtung 9, wie in Fig. 3 gezeigt, lediglich im Bereich der Öffnungen der Kanäle 7, 7' angeordnet sein, oder sie kann den Grundkörper 8 entlang seiner gesamten Oberfläche überziehen, wie in Fig.6 gezeigt. Denkbar ist auch, dass zumindest ein Kanal 7,7' mit wenigstens einer nicht gezeigten an der Oberfläche des Bauteils 1 mündenden Austrittsöffnung kommuniziert und dadurch eine Filmkühlung entlang der Oberfläche 6 erzeugt.

Um die Kühlwirkung der Kanäle 7, 7' voll zu entfalten, müssen diese in einen Kühlkreis der Strömungsmaschine eingebunden sein, so dass ein Durchströmen von Kühlmittel durch die Kanäle 7,7' erreicht werden kann. Denkbar ist auch, dass mehrere Kanäle 7, 7' ein kommunizierendes Kanalnetz bilden, was gemäß Fig. 3 mit einem unterbrochen gezeichneten Verbindungskanal 11 dargestellt ist. Des weiteren ist es für eine effektive Kühlung der Schaufel 3 bzw. des Bauteils 1 erforderlich, dass die Kanäle 7, 7' möglichst dicht an der Oberfläche 6 des Bauteils 1 liegen. Deshalb ist eine Kanallängsachse 12, welche gemäß Fig. 3 im wesentlichen orthogonal zur Bildebene verläuft, weniger als 3 mm von der Oberfläche 6 des Bauteils 1 bzw. der Schaufel 3 beabstandet.

Des weiteren ist ein Längen-/Durchmesserverhältnis zumindest eines Kanals 7,7' größer als fünf. Um darüber hinaus einen zuverlässigen Verschluss des Kanals 7,7' zur Oberfläche 6 des Bauteils 1 hin zu gewährleisten, ist eine Breite der Vertiefung bzw. des Kanals 7,7' kleiner als 1 mm, vorzugsweise im Bereich von ca. 0,2 mm. Dabei sind gemäß Fig. 3 unterschiedliche Querschnittsformen der Kanäle 7 und 7' dargestellt, wobei sich der Kanal 7 zur Oberfläche 6 des Bauteils hin in seiner Breite verjüngt, während der Kanal 7' eine konstante Breite aufweist.

In Fig. 4 ist ein direkt überbrückter Kanal 7 gezeigt, wobei die Beschichtung 9 im Bereich des Kanals 7 einen säulenartigen Aufbau aus feinen Dendriten aufweist. Die Orientierung der Dendrite ist dabei parallel zur Orientierung des Substrates des Grundkörpers 8 und zugleich epitaxial mit dem Substrat verfestigt. Dies ist insbesondere dann vorteilhaft, wenn das Bauteil 1 bzw. die Schaufel 3 einer zyklischen thermischen und mechanischen Belastung unterworfen ist, wie dies beispielsweise bei Gasturbinen der Fall ist. In Fig. 4 ist exemplarisch angedeutet, dass die zur Beschichtung 9 hin orientierten Seitenränder des Kanals 7 beim Anbringen der Beschichtung 9 ab- bzw. aufschmelzen können und anschließend von der ursprünglichen Gestalt stark abweichen können.

Gemäß Fig. 5 ist ein nach der gleichen Methode hergestellter Kanal 7 gezeigt, wobei hier im Anschluss an das Aufbringen der Beschichtung 9 das Gefüge z.B. mittels eines Laseraufschmelzens in vorteilhafter Weise modifiziert wurde. Außerdem kann vor der Metallumformung, insbesondere mittels eines Lasers, der Grundkörper 8 vorgewärmt worden sein. Als Vorwärmtemperatur kommen beispielsweise 1.100°C in Betracht, wodurch hohe Temperaturgradienten innerhalb der Interaktionszone, also innerhalb einer Verbindungszone zwischen Beschichtung 9 und Grundkörper 8 verringert werden können. Gleichzeitig tragen die durch das Erwärmen des Grundmaterials höhere Duktilität desselben sowie die geringeren Temperaturgradienten zu einer Reduzierung einer Rissgefahr während der Verfestigung der Beschichtung 9 bei.

Im Folgenden soll kurz ein Verfahren zur Herstellung zumindest eines in eine Außenwand 5 eines Bauteils 1 einer Strömungsmaschine eingebetteten Kanals 7 durch Beschichten der Außenoberfläche 6 beschrieben werden.

In einem ersten Verfahrensschritt wird zunächst eine kanalartige Vertiefung, sprich ein Kanal 7,7', in den Grundkörper 8 des Bauteils 1 eingebracht. Dies kann beispielsweise mechanisch und/oder elektrochemisch und/oder photo-chemisch und/oder mittels eines Lasers, insbesondere mittels eines Kurzpulslasers erfolgen.

Danach erfolgt ein lokales oberflächiges Aufschmelzen des Grundkörpers 8 zumindest beiderseits des Kanals 7,7', wobei auch hier zum Aufschmelzen des Grundkörpers 8 wiederum ein Laser eingesetzt werden kann.

In einem Arbeitsgang mit dem Aufschmelzen des Grundkörpers 8 erfolgt das Auftragen und Aufschmelzen einer Beschichtung 9 zumindest im Bereich des Kanals 7,7', wobei die Beschichtung 9, die Prozesstemperatur und die Breite des Kanals 7,7' so aufeinander abgestimmt sind, dass das aufgeschmolzene Beschichtungsmaterial infolge seiner Oberflächenspannung nicht in den Kanal 7,7' eindringt. Es wird somit kein Füllmaterial zum Verschließen des Kanals 7,7', wie dies bei den Herstellungsprozessen nach dem Stand der Technik der Fall ist, benötigt. Vielmehr wird beispielsweise ein Metallpuder verwendet, welcher im geschmolzenen Zustand aufgrund seiner Oberflächenspannung eine Brücke über den Kanal 7,7' bildet und dadurch diesen zur Oberfläche 6 des Bauteils 1 hin verschließt. Wichtig ist für eine bevorzugte Ausführungsform, dass die Materialeigenschaften des Beschichtungspulvers auf den jeweiligen Beschichtungs-Prozess so zugeschnitten sind, dass die Entstehung eines einkristallinen Gefüges begünstigt wird. Das Aufbringen der Beschichtung 9 auf den Grundkörper 8 kann beispielsweise mittels Plasma-Sprühen und/oder mittels eines Elektronenstrahl-Verdampfungs-Prozesses und/oder mittels eines Lasers erfolgen. Bevorzugt wird ein LMF-Verfahren (Laser Metal Forming), insbesondere ein E-LMF-Vefahren (Epitaxial-LMF) zur Erzeugung einer epitaktischen, also einer einkristallinen Beschichtung 9 auf dem vorzugsweise ebenfalls einkristallinen Grundkörper 8.

Abschließend kann ein kontrolliertes Abkühlen und Verfestigen des geschmolzenen Beschichtungsmaterials erfolgen, derart, dass eine metallurgische Anbindung zum Grundkörper 8 beiderseits des Kanals 7,7' erreicht und der Kanal 7,7' zur Oberfläche 6 hin vom erstarrenden Beschichtungsmaterial überbrückt wird. Die Oberfläche 6 kann daraufhin nachträglich mittels eines Lasers bearbeitet und/oder geglättet werden, wodurch eine veredelte Oberfläche 6 erzielt werden kann. Diese "Veredelung" besteht vorzugsweise in der Schaffung einer einkristallinen Struktur innerhalb der Beschichtung 9.

Die Querschnittsform und die Abmessung des Kanals 7,7' können dabei exakt gesteuert werden, wodurch die gewünschte Querschnittsform des Kanals 7,7' relativ exakt gebildet werden und auch der Verlauf des Kanals 7,7' weitgehend exakt definiert werden können.

Mit Hilfe eines LMF-Verfahrens können das Aufschmelzen des Grundkörpers 8 und das Auftragen sowie Aufschmelzen des Beschichtungsmaterials simultan durchgeführt werden, was das Aufbringen der Beschichtung 9 vereinfacht. Die Verwendung eines E-LMF-Verfahrens schafft durch geeignete Wahl der Verfahrensparameter die Möglichkeit, die Beschichtung 9 einkristallin erstarren zu lassen, wobei sich gleichzeitig die Möglichkeit bietet, für die Beschichtung 9 und für den Grundkörper 8 im wesentlichen dieselbe kristallographische Ausrichtung zu erzeugen. Durch diese nach der Abkühlung gleiche kristallographische Ausrichtung der Beschichtung 9 und des Grundkörpers 8 durch die sich ausbreitenden Dentritarme und das säulenartige Wachstum können die thermophysikalischen Eigenschaften des Beschichtungsmaterials gleich denen des Grundkörpers 8 sein, wodurch die Lebensdauer erhöht werden kann.

Wie bereits weiter oben angedeutet, können das Aufbringen der Beschichtung 9 und die Oberflächenveredelung als Zwei-Stufen-Prozess ausgestaltet werden, bei dem in einer ersten Stufe die Beschichtung 9 mit Hilfe eines geeigneten Verfahrens (siehe oben) auf den Grundkörper 8 aufgebracht werden kann, und bei dem in einer zweiten Stufe mittels eines geeigneten Umschmelzverfahrens, z.B. mit Hilfe eines geeigneten Lasers, das einkristalline Gefüge innerhalb der Beschichtung 9 realisiert werden kann.

Durch die erfindungsgemäße Anordnung bzw. Herstellung der Kühlkanäle 7,7' kann eine effektive Kühlung des Bauteils 1 erreicht werden und somit die erträgliche Turbineneingangstemperatur um 50K bis 125K gesteigert werden. Selbstverständlich können die gemäß der Erfindung hergestellten Kanäle 7,7' auch mit anderen Kühlverfahren, wie beispielsweise einem Transpirationskühlverfahren, kombiniert werden.

Entsprechend Fig. 6 kann die Beschichtung 9 bei einer anderen Ausführungsform auch so auf den Grundkörper 8 aufgebracht werden, dass sie sich über mehrere Kanäle 7,7' erstreckt bzw. einen mehrere Kanäle 7,7' umfassenden Abschnitt des Grundkörpers 8 bedeckt. Insbesondere ist es möglich, die gesamte, der thermischen Belastung ausgesetzte Oberfläche 6 des jeweiligen Bauteils 1 zunächst mit der Beschichtung 9 und anschließend mit der Wärmeschutzschicht 10 zu versehen.

Des weiteren kann beim Aufbringen der Beschichtung 9 darauf geachtet werden, dass eine erste Phase der Verfestigung des Beschichtungsmaterials vom γ-Typ ist. Zusätzlich oder alternativ kann durch Einstellen der Verfahrensparameter darauf geachtet werden, dass ein sogenannter CET (Columnar to Equiaxed Transition), also ein Übergang von einer gerichteten zu einer globulitischen Kristallstruktur vermieden wird. Zusätzlich oder alternativ ist es hierzu zweckmäßig, die Verfahrensparameter und das Beschichtungsmaterial so zu wählen, dass nach Möglichkeit die Ausbildung neuer Kristallisationskeime beim Aufbringen der Beschichtung 9 vermieden wird. Auf diese Weise kann insbesondere ein epitaxialer Aufbau der Beschichtung 9 auf den Grundkörper 8 erzielt werden.

Grundsätzlich ist es möglich, dass sich die für den Grundkörper 8 bevorzugte Einkristallstruktur durch das Aufbringen der Beschichtung 9 verändert. Zweckmäßig kann mit Hilfe eines zusätzlichen Aufschmelzvorgangs eine Wiederherstellung der Einkristallstruktur des Grundkörpers 8 erzielt werden. Dieser zusätzliche Aufschmelzvorgang kann beispielsweise gleichzeitig mit dem Aufschmelzen der Beschichtung 9 durchgeführt werden, um in dieser eine polykristalline Struktur in eine Einkristallstruktur zu transformieren.

### Bezugszeichenliste

- 1: Bauteil
- 2: Heißgas beaufschlagter Bereich
- 3: Schaufel
- 4: Schaufelfuß
- 5: Außenwand
- 6: Oberfläche
- 7,7': Kanal/Vertiefung
- 8: Grundkörper
- 9: Beschichtung
- 10: TemperaturNVärmeschutzschicht
- 11: Verbindungskanal
- 12: Kanallängsachse

## Patentansprüche

1. Verfahren zur Herstellung eines Bauteils (1), insbesondere einer Heissgaskomponente einer Strömungsmaschine, mit zumindest einem in eine Außenwand (5) des Bauteils (1) eingebetteten Kanal (7,7'), bei dem zumindest eine kanalartige Vertiefung (7,7') in einen Grundkörper (8) des Bauteils (1) eingebracht wird, und diese kanalartige Vertiefung (7,7') anschliessend durch Auftragen eines Beschichtungsmaterials (9) auf den Grundkörper (8) abgedeckt wird, **dadurch gekennzeichnet,**
**dass** der Grundkörper (8) zumindest beiderseits der Vertiefung (7,7') lokal oberflächlich aufgeschmolzen wird unter gleichzeitigem Auftragen und Aufschmelzen des Beschichtungsmaterials (9) zumindest im Bereich der Vertiefungen (7,7'), wobei Beschichtungsmaterial (9), Prozesstemperatur und Breite der Vertiefung (7,7') so aufeinander abgestimmt sind, dass das aufgeschmolzene Beschichtungsmaterial (9) infolge seiner Oberflächenspannung nicht in die Vertiefung (7,7') eindringt, und ein kontrolliertes Abkühlen und Verfestigen des geschmolzenen Beschichtungsmaterials (9) durchgeführt wird, dergestalt, dass sich das Beschichtungsmaterial (9) epitaxial auf den Grundkörper (8) aufbaut, so dass eine metallurgische Anbindung zum Grundkörper (8) beiderseits der Vertiefung erreicht wird.

2. Verfahren nach Anspruch 1,
**dadurch gekennzeichnet,**
**dass** das gleichzeitige Aufschmelzen des Grundkörpers (8) und das Aufbringen des Beschichtungsmaterials (9) mittels eines Plasmasprühverfahrens und/oder eines Elektronenstrahl-Verdampfungsverfahrens und/oder mittels eines Laser-Verfahrens, insbesondere eines Epitaxial-Laser-Metall-Auftragsverfahrens (epitaxial laser metal forming) erfolgt.

3. Verfahren nach Anspruch 2,
**dadurch gekennzeichnet,**
**dass** das Beschichtungsmaterial in Form von Pulver oder Draht zugeführt wird.

4. Verfahren nach Anspruch 1,
**dadurch gekennzeichnet,**
**dass** das Einbringen der Vertiefung (7,7') in den Grundkörper mittels Präzisions-Feinguss und/oder mechanisch und/oder elektro-chemisch und/oder photo-chemisch und/oder mittels eines Lasers erfolgt.

5. Verfahren nach Anspruch 1,
**dadurch gekennzeichnet,**
- **dass** eine erste Phase der Verfestigung des Beschichtungsmaterials (9) vom γ-Typ ist, und/oder
- **dass** in der Beschichtung (9) ein Übergang von der Einkristallstruktur zur Gleichachsenstruktur vermieden wird, und/oder
- **dass** in der Beschichtung (9) die Ausbildung neuer Kristallisationskeime vermieden wird.

6. Verfahren nach Anspruch 1,
**dadurch gekennzeichnet,**
**dass** die Oberfläche der Beschichtung (9) in einer Nachbehandlungsstufe durch Aufschmelzen mittels eines Lasers geglättet wird.

7. Verfahren nach Anspruch 1,
**dadurch gekennzeichnet,**
**dass** der Grundkörper (8) vor und/oder während des Beschichtens erwärmt wird, um auftretende Spannungen durch das Verfestigen und/oder Abkühlen der Beschichtung (9) zu reduzieren.

8. Verfahren nach Anspruch 1,
**dadurch gekennzeichnet,**
**dass** die Beschichtung (9) so aufgebracht oder nachbehandelt wird, dass sie eine einkristalline Struktur erhält und/oder epitaktisch an den Grundkörper (8) angebunden ist.

9. Verfahren nach Anspruch 1,
**dadurch gekennzeichnet,**
**dass** ein zusätzlicher Aufschmelzvorgang durchgeführt wird, dergestalt, dass eine Einkristallstruktur des Grundkörpers (8) wiederhergestellt wird und/oder dass eine polykristalline Struktur der Beschichtung (9) in eine Einkristallstruktur transformiert wird.

10. Bauteil einer Strömungsmaschine, hergestellt nach einem Verfahren gemäss Anspruch 1, mit zumindest einem in eine Außenwand (5) des Bauteils (1) eingebetteten und im wesentlichen parallel zur Oberfläche des Bauteils (1) verlaufenden Kanal (7,7'), welcher insbesondere zur Durchleitung eines Kühlmittels dient, wobei das Bauteil (1) einen Grundkörper (8) und zumindest eine außenseitig darauf aufgebrachte Beschichtung (9) aufweist., und der mindestens eine Kanal (7,7') einerseits durch eine in den Grundkörper (8) eingebrachte Vertiefung gebildet ist und andererseits zur Oberfläche (6) des Bauteils (1) hin durch die Beschichtung (9) verschlossen ist, wobei das Beschichtungsmaterial (9) ein einkristallines, epitaktisch an den einkristallinen Grundkörper (8) angebundenes Gefüge aufweist,
**dadurch gekennzeichnet,**
**dass** eine Kanallängsachse (12) des zumindest einen Kanals (7,7') weniger als 3 mm von der Oberfläche (6) des Bauteils (1) beabstandet ist, dass ein Längen-/Durchmesserverhältnis des zumindest einen Kanals (7,7') größer als 5 ist, und dass eine Breite der kanalartigen Vertiefung (7,7') kleiner als 1 mm ist.

11. Bauteil nach Anspruch 10,
**dadurch gekennzeichnet,**
**dass** die Kanallängsachse (12) weniger als 1 mm von der Oberfläche (6) des Bauteils (1) beabstandet ist.

12. Bauteil nach Anspruch 10,
**dadurch gekennzeichnet,**
**dass** die Breite der kanalartigen Vertiefung (7,7') zwischen 0,02 mm und 0,5 mm, besonders bevorzugt zwischen 0,1 mm bis 0,3 mm, ist.

13. Bauteil nach Anspruch 10,
**dadurch gekennzeichnet,**
**dass** der Grundkörper (8) des Bauteils (1) aus einer nickelbasierten Legierung hergestellt ist.

14. Bauteil nach Anspruch 10,
**dadurch gekennzeichnet,**
**dass** die Beschichtung (9) aus demselben Material besteht wie der Grundkörper (8).

15. Bauteil nach Anspruch 10,
**dadurch gekennzeichnet,**
**dass** die Beschichtung (9) eine MCrALY-Legierung ist, wobei M Nickel, Cobalt, Eisen oder eine Kombination aus diesen Elementen ist.

16. Bauteil nach Anspruch 10,
**dadurch gekennzeichnet,**
**dass** der zumindest eine Kanal (7,7') in einen Kühlkreis der Strömungsmaschine eingebunden ist.

17. Bauteil nach Anspruch 16,
**dadurch gekennzeichnet,**
**dass** der zumindest eine Kanal (7,7') mit wenigstens einer an der Oberfläche (6) des Bauteils (1) mündenden Austrittsöffnung kommuniziert.

18. Bauteil nach Anspruch 10,
**dadurch gekennzeichnet,**
**dass** die Beschichtung (9) außen eine Wärmeschutzschicht (10) trägt.

19. Bauteil nach Anspruch 10,
**dadurch gekennzeichnet,**
**dass** sich die Beschichtung (9) über mehrere Kanäle (7,7') erstreckt.

20. Bauteil nach einem der Ansprüche 10 bis 19,
**dadurch gekennzeichnet,**
**dass** mehrere Kanäle (7,7') ein kommunizierendes Kanalnetz bilden.

21. Bauteil nach einem der Ansprüche 10 bis 20,
**dadurch gekennzeichnet,**
**dass** sich die Vertiefung (7,7') zur Oberfläche (6) des Bauteils (1) hin in der Breite verjüngt.

22. Bauteil nach Anspruch 10,
**dadurch gekennzeichnet,**
**dass** das Bauteil (1) eine Schaufel (3) oder ein Wärmeschutzelement einer Turbine ist.

## Claims

1. Method for producing a component (1), especially a hot gas component of a turbomachine, with at least one passage (7, 7') which is embedded in an outer wall (5) of the component (1), in which method at least one passage-like cavity (7, 7') is introduced in a basic body (8) of the component (1), and this passage-like cavity (7, 7') is then covered by applying a coating material (9) to the basic body (8),
**characterized in that**
the basic body (8) is locally surface melted, at least on the two sides of the cavity (7, 7'), while simultaneously applying and melting the coating material (9) at least in the region of the cavities (7, 7'), wherein coating material (9), process temperature and width of the cavity (7, 7') are matched to each other so that the molten coating material (9) does not penetrate into the cavity (7, 7') on account of its surface tension, and a controlled cooling and hardening of the molten coating material (9) is carried out in such a way that the coating material (9) is epitaxially built up on the basic body (8) so that a metallurgical connection to the basic body (8) is achieved on the two sides of the cavity.

2. Method according to Claim 1,
**characterized in that**
the simultaneous melting of the basic body (8) and the applying of the coating material (9) is carried out by means of a plasma spraying method and/or an electron beam evaporation method and/or by means of a laser method, especially an epitaxial laser metal forming method.

3. Method according to Claim 2,
**characterized in that**
the coating material is fed in the form of powder or wire.

4. Method according to Claim 1,
**characterized in that**
the introducing of the cavity (7, 7') in the basic body is carried out by means of precision investment casting and/or mechanically and/or electrochemically and/or photochemically and/or by means of a laser.

5. Method according to Claim 1,
**characterized in that**
- a first phase of the hardening of the coating material (9) is of the γ-type, and/or
- in the coating (9), a transition from the monocrystal structure to the equiaxial structure is avoided, and/or
- in the coating (9), the formation of new crystallization germs is avoided.

6. Method according to Claim 1,
**characterized in that**
the surface of the coating (9) is smoothed in an aftertreatment step by melting by means of a laser.

7. Method according to Claim 1,
**characterized in that**
the basic body (8) is heated before and/or during coating, in order to reduce stresses which occur by the hardening and/or cooling of the coating (9).

8. Method according to Claim 1,
**characterized in that**
the coating (9) is applied or aftertreated so that it contains a monocrystalline structure and/or is epitaxially connected to the basic body (8).

9. Method according to Claim 1,
**characterized in that**
an additional melting process is carried out in such a way that a monocrystal structure of the basic body (8) is reproduced and/or a polycrystalline structure of the coating (9) is transformed into a monocrystal structure.

10. Component of a turbomachine, produced according to a method according to Claim 1, with at least one passage (7, 7') which is embedded in an outer wall (5) of the component (1) and basically extends parallel to the surface of the component (1), which passage especially serves for the conducting of a cooling medium, wherein the component (1) has a basic body (8) and at least one coating (9) which is applied to it on the outside, and the at least one passage (7, 7') on one hand is formed by means of a cavity which is introduced in the basic body (8), and on the other hand is closed off towards the surface (6) of the component (1) by means of the coating (9), wherein the coating material (9) has a monocrystalline structure which is epitaxially connected to the monocrystalline basic body (8),
**characterized in that**
a passage longitudinal axis (12) of the at least one passage (7, 7') is at a distance of less than 3 mm from the surface (6) of the component (1), **in that** a length/diameter ratio of the at least one passage (7, 7') is greater than 5, and **in that** a width of the passage-like cavity (7, 7') is less than 1 mm.

11. Component according to Claim 10,
**characterized in that**
the passage longitudinal axis (12) is at a distance of less than 1 mm from the surface (6) of the component (1).

12. Component according to Claim 10,
**characterized in that**
the width of the passage-like cavity (7, 7') is between 0.02 mm and 0.5 mm, especially preferably between 0.1 mm and 0.3 mm.

13. Component according to Claim 10,
**characterized in that**
the basic body (8) of the component (1) is produced from a nickel-based alloy.

14. Component according to Claim 10,
**characterized in that**
the coating (9) comprises the same material as the basic body (8).

15. Component according to Claim 10,
**characterized in that**
the coating (9) is an MCrALY alloy, wherein M is nickel, cobalt, iron or a combination of these elements.

16. Component according to Claim 10,
**characterized in that**
the at least one passage (7, 7') is integrated in a cooling circuit of the turbomachine.

17. Component according to Claim 16,
**characterized in that**
the at least one passage (7, 7') communicates with at least one discharge opening which leads to the surface (6) of the component (1).

18. Component according to Claim 10,
**characterized in that**
the coating (9) supports a thermal protection layer (10) on the outside.

19. Component according to Claim 10,
**characterized in that**
the coating (9) extends across a plurality of passages (7, 7').

20. Component according to one of Claims 10 to 19,
**characterized in that**
a plurality of passages (7, 7') forms a communicating passage network.

21. Component according to one of Claims 10 to 20,
**characterized in that**
the cavity (7, 7') tapers in width towards the surface (6) of the component (1).

22. Component according to Claim 10,
**characterized in that**
the component (1) is a blade (3) or a thermal protection element of a turbine.

## Revendications

1. Procédé de fabrication d'un composant (1), notamment d'un composant à gaz chaud d'une turbomachine, avec au moins un canal (7, 7') incorporé dans la paroi extérieure (5) du composant (1), au cours duquel on ménage au moins un creux de type canal (7, 7') dans un corps de base (8) du composant (1), et on recouvre ensuite ce creux de type canal (7, 7') par application d'une matière de revêtement (9) sur le corps de base (8), **caractérisé en ce qu'**on fait fondre localement et superficiellement le corps de base (8) au moins de part et d'autre du creux (7, 7') en appliquant et en faisant fondre simultanément la matière de revêtement (9) au moins dans la zone des creux (7, 7'), la matière de revêtement (9), la température du processus et la largeur du creux (7, 7') étant adaptées les unes aux autres de sorte que, du fait de sa tension superficielle, la matière de revêtement (9) fondue ne pénètre pas dans le creux (7, 7') et un refroidissement et un durcissement contrôlés de la matière de revêtement (9) fondue étant réalisés, de telle sorte que la matière de revêtement (9) se constitue par épitaxie sur le corps de base (8), de sorte qu'une liaison métallurgique soit obtenue avec le corps de base (8), de part et d'autre du creux.

2. Procédé selon la revendication 1, **caractérisé en ce que** les opérations simultanées de fusion du corps de base (8) et d'application de la matière de revêtement (9) s'effectuent au moyen d'un procédé de vaporisation par plasma et/ou d'un procédé d'évaporation par bombardement électronique et/ou au moyen d'un procédé au laser, notamment d'un procédé par dépôt épitaxique de métaux au laser (epitaxial laser metal forming).

3. Procédé selon la revendication 2, **caractérisé en ce qu'**on alimente la matière de revêtement sous la forme de poudre ou d'un fil métallique.

4. Procédé selon la revendication 1, **caractérisé en ce que** l'introduction du creux (7, 7') dans le corps de base s'effectue au moyen d'un moulage de précision et/ou par voie mécanique et/ou électrochimique et/ou photochimique et/ou au moyen d'un laser.

5. Procédé selon la revendication 1, **caractérisé en ce**
- **qu'**une première phase du durcissement de la matière de revêtement (9) est de type y et/ou
- en ce que dans le revêtement (9), on empêche un passage de la structure monocristalline à une structure équiaxe et/ou
- en ce que dans le revêtement (9), on empêche la formation de nouveaux germes de cristallisation.

6. Procédé selon la revendication 1, **caractérisé en ce qu'**on lisse la surface du revêtement (9) dans une étape de post-traitement par fusion au laser.

7. Procédé selon la revendication 1, **caractérisé en ce qu'**on chauffe le corps de base (8) avant et/ou pendant l'opération de revêtement, pour réduire des tensions naissantes du fait du durcissement et/ou du refroidissement du revêtement (9).

8. Procédé selon la revendication 1, **caractérisé en ce qu'**on applique ou qu'on post-traite le revêtement (9), afin de lui conférer une structure monocristalline et/ou de le relier par épitaxie au corps de base (8).

9. Procédé selon la revendication 1, **caractérisé en ce qu'**on procède à un processus d'ouverture par fusion, de sorte qu'une structure monocristalline du corps de base (8) soit rétablie et/ou qu'une structure polycristalline du revêtement (9) se transforme en une structure monocristalline.

10. Composant d'une turbomachine, fabriqué d'après un procédé selon la revendication 1, avec au moins un canal (7, 7') incorporé dans une paroi extérieure (5) du composant (1) et s'étendant sensiblement à la parallèle de la surface du composant (1), qui est destiné notamment à la circulation d'un agent réfrigérant, le composant (1) comportant un corps de base (8) et au moins un revêtement (9) appliqué sur sa face extérieure et l'au moins un canal (7, 7') étant d'une part formé par un creux ménagé dans le corps de base (8) et étant d'autre part fermé vers la surface (6) du composant (1) par le revêtement (9), la matière de revêtement (9) comportant une structure monocristalline reliée par épitaxie au corps de base (8) monocristallin, **caractérisé en ce qu'**un axe longitudinal de canal (12) de l'au moins un canal (7, 7') est écarté de moins de 3 mm de la surface (6) du composant (1), **en ce qu'**un rapport longueur/diamètre de l'au moins un canal (7, 7') est supérieur à 5 et **en ce qu'**une largeur du creux de type canal (7, 7') est inférieure à 1 mm.

11. Composant selon la revendication 10, **caractérisé en ce que** l'axe longitudinal du canal (12) est écarté de moins de 1 mm de la surface (6) du composant (1).

12. Composant selon la revendication 10, **caractérisé en ce que** la largeur du creux de type canal (7, 7') est comprise entre 0,02 mm et 0,5 mm, de manière particulièrement préférée de 0,1 mm à 0,3 mm.

13. Composant selon la revendication 10, **caractérisé en ce qu'**on fabrique le corps de base (8) du composant (1) à partir d'un alliage à base de nickel.

14. Composant selon la revendication 10, **caractérisé en ce que** le revêtement (9) se compose de la même matière que le corps de base (8).

15. Composant selon la revendication 10, **caractérisé en ce que** le revêtement (9) est un alliage de MCrALY, M étant du nickel, du cobalt, du fer ou une association de ces éléments.

16. Composant selon la revendication 10, **caractérisé en ce que** l'au moins un canal (7, 7') est inclus dans un circuit de refroidissement de la turbomachine.

17. Composant selon la revendication 16, **caractérisé en ce que** l'au moins un canal (7, 7') communique avec au moins un orifice de sortie débouchant sur la surface (6) du composant (1).

18. Composant selon la revendication 10, **caractérisé en ce que** le revêtement (9) porte sur l'extérieur une couche calorifuge (10).

19. Composant selon la revendication 10, **caractérisé en ce que** le revêtement (9) s'étend sur plusieurs canaux (7, 7').

20. Composant selon l'une quelconque des revendications 10 à 19, **caractérisé en ce que** plusieurs canaux (7, 7') forment un réseau de canaux communicants.

21. Composant selon l'une quelconque des revendications 10 à 20, **caractérisé en ce que** le creux (7, 7') se rétrécit en direction de la surface (6) du composant (1).

22. Composant selon la revendication 10, **caractérisé en ce que** le composant (1) est une pale (3) ou un élément calorifuge d'une turbine.
